Europäisches Patentamt

European Patent Office

Office européen des brevets

(19)

(11) Numéro de publication : **0 497 694 A1**

# (12) DEMANDE DE BREVET EUROPEEN

(21) Numéro de dépôt : **92400230.6**

(22) Date de dépôt : **29.01.92**

(51) Int. Cl.⁵ : **H03K 17/969**

(30) Priorité : **31.01.91 FR 9101091**

(43) Date de publication de la demande :
**05.08.92 Bulletin 92/32**

(84) Etats contractants désignés :
**AT BE CH DE DK ES FR GB GR IT LI LU MC NL PT SE**

(71) Demandeur : **Battarel, Claude**
**La Cour**
**F-61420 FONTENAI LES LOUVETS (FR)**

(72) Inventeur : **Battarel, Claude**
**La Cour**
**F-61420 FONTENAI LES LOUVETS (FR)**

(74) Mandataire : **Bloch, Gérard**
**2, square de l'Avenue du Bois**
**F-75116 Paris (FR)**

(54) **Clavier optique matriciel.**

(57) Un clavier optique matriciel est muni de touches mobiles entre une position relâchée et une position enfoncée, chaque touche comportant des moyens d'interruption pour interrompre, en vu de l'identification de la touche, au moins un faisceau lumineux.Les moyens d'interruption (4) sont agencés pour laisser passer ledit faisceau lorsque la touche est en position relâchée ou en position enfoncée, et pour interrompre le faisceau pendant une fraction de la course de la touche entre ses positions relâchée et enfoncée.

FIG.1

EP 0 497 694 A1

La présente invention concerne un clavier optique matriciel et notamment un tel clavier muni de touches mobiles entre une position relâchée ou haute et une position enfoncée ou basse, chaque touche comportant des moyens d'interruption aptes à interrompre, en vue de l'identification de la touche, au moins deux faisceaux lumineux.

Dans les claviers de ce type décrits par exemple dans le document US-A-3 056 030, des sources de lumière sont disposées sur deux des bords adjacents du clavier et des récepteurs de lumière sur les deux autres bords qui leur font face, les touches étant disposées aux emplacements de croisement de deux faisceaux lumineux. Lorsqu'une touche est enfoncée, elle interrompt les deux faisceaux lumineux correspondant à son emplacement, les deux récepteurs correspondant à ces faisceaux détectent cette interruption, et des moyens de traitement associés aux récepteurs permettent d'identifier la touche enfoncée. Ces claviers de l'art antérieur ne permettent pas toutefois une frappe très rapide dans laquelle plusieurs touches peuvent être enfoncées simultanément dans un ordre et une disposition quelconque.

En effet, la position enfoncée d'une touche fait passer les deux faisceaux lumineux reliant un émetteur de colonne et un émetteur de rangée à leur détecteur associé de l'état passant à l'état bloqué ou vice et versa. En conséquence, si plusieurs touches sont enfoncées simultanément, il peut en résulter un masquage de touches enfoncées qui ne donneront alors lieu à aucun signal.

La présente invention vise à pallier cet inconvénient en fournissant notamment un clavier optique matriciel dans lequel plusieurs touches peuvent être enfoncées simultanément dans un ordre quelconque.

Un autre but de l'invention est de fournir un clavier optique matriciel dans lequel le nombre de détecteurs de lumière est réduit, et notamment un tel clavier comportant un seul détecteur de lumière.

A cet effet, l'invention a pour objet un clavier optique matriciel muni de touches mobiles entre une position relâchée et une position enfoncée, chaque touche comportant des moyens d'interruption aptes à interrompre, en vue de l'identification de la touche, au moins un faisceau lumineux, caractérisé par le fait que lesdits moyens d'interruption sont agencés pour laisser passer ledit faisceau lorsque la touche est en position relâchée ou en position enfoncée, et pour interrompre ledit faisceau pendant une fraction de la course de la touche entre ses positions relâchée et enfoncée.

Par conséquent, dans l'invention les touches laissent passer la lumière en position haute de repos mais aussi en position basse de touche enfoncée. Les moyens d'interruption bloquent uniquement transitoirement le passage de la lumière à mi-chemin pendant la course de descente ou de remontée de la touche, ce qui constitue le signal.

Ce bloquage transitoire de la lumière peut être effectué soit uniquement dans les rangées, soit uniquement dans les colonnes, soit dans les rangées et dans les colonnes, un traitement approprié du signal de sortie permettant alors de distinguer les touches enfoncées simultanément puisque les touches enfoncées laissent encore passer la lumière et donnent lieu à un nouveau signal pour toute autre touche nouvellement enfoncée.

Dans un premier mode de réalisation, lesdits moyens d'interruption comprennent une base rigidement reliée au cabochon de la touche, ladite base ayant dans la direction de déplacement de la touche, une dimension inférieure à la course de la touche.

En d'autres termes, lorsque la touche est en position relâchée, la base reliée au cabochon de la touche se trouve au-dessus du faisceau. Lorsque la touche est en position enfoncée, cette base se trouve en-dessous du faisceau qu'elle interrompt par conséquent transitoirement soit au cours de l'enfoncement de la touche, soit au cours sa remontée.

Dans un autre mode de réalisation, les moyens d'interruption comprennent également une base rigidement reliée au cabochon de la touche, cette base comportant alors au moins un conduit de lumière pour laisser passer le faisceau lumineux lorsque la touche est en position enfoncée, la cloison inférieure dudit conduit ayant une épaisseur inférieure à la course de la touche.

Plus particulièrement, la base peut comporter deux conduits de lumière superposés pour laisser passer le faisceau lumineux lorsque la touche est dans ses positions relâchée et enfoncée respectivement, la cloison de séparation entre lesdits conduits ayant une épaisseur inférieure à la course de la touche pour interrompre transitoirement le faisceau lumineux lors de l'enfoncement ou du relâchement de la touche.

Les moyens d'interruption sont de préférence agencés pour interrompre deux faisceaux lumineux, les fractions de la course de la touche pendant lesquelles les deux faisceaux lumineux sont interrompus étant décalées.

Il en résulte un déphasage entre les signaux de rangées et les signaux de colonnes, ce qui permet de distinguer la transition d'abaissement de la touche de celle du relevé de la touche.

Dans le cas précité de l'utilisation de deux faisceaux lumineux, les moyens d'interruption peuvent être agencés pour interrompre un desdits faisceaux pendant une fraction de la course de la touche comprenant la position enfoncée de la touche.

Par conséquent, dans ce mode de réalisation, la touche est disposée comme une touche conventionnelle par rapport à l'un des deux faisceaux qui peut être soit le faisceau de rangée, soit le faisceau de colonne, mais le traitement du signal qui en résulte est bien entendu différent.

Dans un mode de réalisation avantageux, la base de chaque touche comprend au moins un conduit de lumière pour chacun des deux faisceaux lumineux, ladite base ayant une forme de croix dont les branches sont parallèles à chacun des faisceaux lumineux.

Une tige de liaison entre la base et le cabochon de la touche est de préférence décentrée par rapport à l'axe de la colonne de la touche et par rapport à l'axe du cabochon, ce qui permet de standardiser les corps et les cabochons des touches.

Dans un autre mode de réalisation, chaque touche consiste en des emplacements déformables d'une membrane, lesdits moyens d'interruption comprenant une saillie excentrée du côté inférieur de la touche, ladite saillie coupant le faisceau lumineux lors de l'enfoncement de la touche par déformation de ladite membrane.

La présente invention a également pour objet un clavier optique matriciel, notamment du type décrit ci-dessus, comprenant une pluralité de sources lumineuses correspondant chacune soit à une rangée de touches, soit à une colonne de touches du clavier matriciel, un détecteur de lumière unique, et des moyens réfléchissants pour réfléchir les différents faisceaux lumineux vers le détecteur de lumière, les sources lumineuses étant activées en séquence.

Dans ce cas, on utilise par conséquent un récepteur unique, l'identification de la touche ayant provoqué une interruption d'un des faisceaux recueilli par le récepteur étant réalisée en fonction de l'instant auquel le détecteur a détecté une interruption du faisceau lumineux.

On peut par exemple prévoir un conduit de lumière monobloc en matériau transparent situé sur les deux bords du clavier opposés aux bords où sont montées les sources lumineuses, les moyens réfléchissants étant constitués de facettes réalisées du côté extérieur du conduit de lumière par rapport au clavier sur lesquelles s'effectue une réflexion totale du faisceau lumineux, le détecteur étant disposé contre le conduit de lumière à l'emplacement où convergent tous les faisceaux réfléchis.

On prévoit de préférence des moyens de mémorisation des interruption des faisceaux lumineux et des moyens de traitement des informations mémorisées pour identifier les touches enfoncées et leur ordre d'enfoncement.

Dans ce cas, et lorsque le clavier comporte une pluralité de sources lumineuses activées cycliquement pour former lesdits faisceaux lumineux, les moyens de mémorisation peuvent comprendre des moyens pour mémoriser les touches ayant donné lieu à un signal au cours du cycle en cours, les touches ayant donné lieu à un signal au cours du cycle précédent, et les touches en position enfoncée depuis plusieurs cycles.

Un traitement approprié du signal de sortie, à la portée de l'homme de métier, permet ainsi de détecter une touche enfoncée en permanence par exemple en vue de la répétition d'un caractère ou encore une touche de fonction telle que la touche "majuscule", et en même temps d'identifier plusieurs touches frappées successivement et très rapidement, une ou plusieurs touches étant encore enfoncées alors qu'une autre touche est en train de l'être.

On décrira maintenant, à titre d'exemple non limitatif, quelques modes de réalisation de l'invention en référence aux dessins schématiques annexés dans lesquels :

– les figs. 1 à 5 représentent cinq modes de réalisation de touches pour un clavier selon l'invention;

– la fig. 6 représente une telle touche vue en coupe;

– la fig. 7 montre l'utilisation de touches selon l'invention dans un clavier cambré;

– la fig. 8 représente un premier mode de réalisation d'un clavier selon l'invention à récepteur unique;

– la fig. 9 est une vue similaire à la fig. 8 d'un autre mode de réalisation;

– la fig. 10 est une vue de détail correspondant à la fig. 9 ;

– la fig. 11 représente un autre mode de réalisation d'une touche selon l'invention; et

– la fig. 12 illustre les signaux procurés par un clavier selon l'invention.

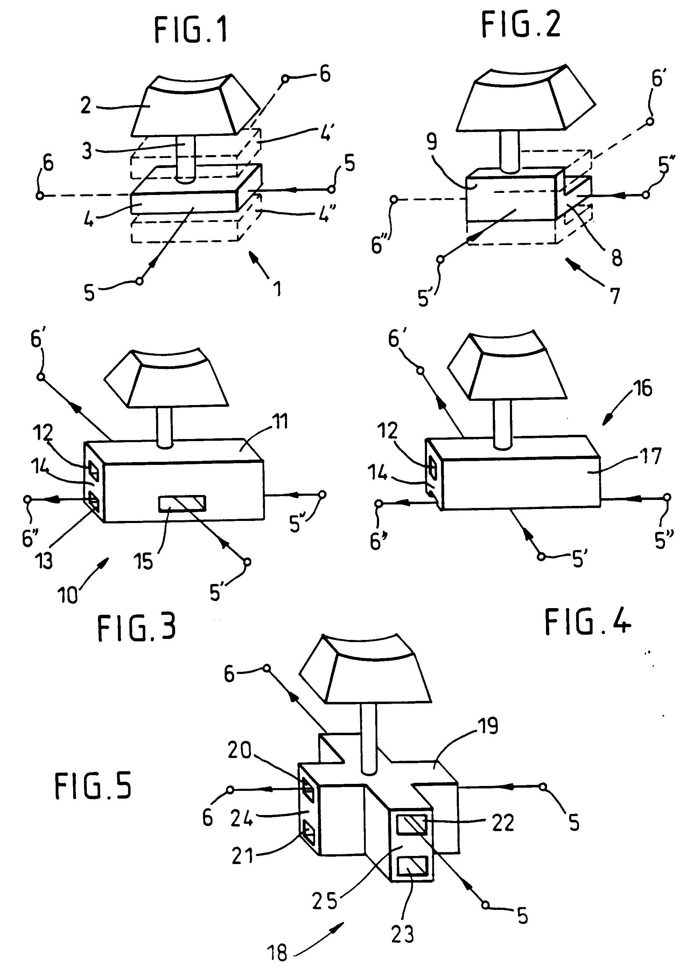

Si l'on se réfère maintenant à la fig. 1, on voit une touche 1 comportant un cabochon 2 relié par une tige 3 à une base 4.

La base 4 est représentée en traits interrompus dans ses positions relâchée et enfoncée 4' et 4" respectivement et en traits pleins dans une position intermédiaire.

La base 4 est ici constituée d'une simple plaque perpendiculaire à la direction de déplacement de la touche 1 et d'épaisseur inférieure à la course de cette touche.

On voit également sur la fig.1 deux sources de lumière 5 éclairant l'une, la rangée dans laquelle se trouve la touche 1 et l'autre, la colonne dans laquelle se trouve cette touche, les faisceaux lumineux issus des sources 5 se croisant à l'emplacement de la touche 1.

Des récepteurs de lumière 6 sont disposés en vis-à-vis des sources 5 afin de détecter le faisceau émis lorsque celui-ci n'est pas interrompu.

On voit sur la fig. 1 que, aussi bien dans la position enfoncée que dans la position relâchée de la touche, les faisceaux issus des sources 5 ne sont pas interrompus et que, par conséquent, les récepteurs délivrent un signal correspondant à la réception d'un faisceau lumineux.

Par contre, aussi bien au cours de l'enfoncement de la touche qu'au cours de sa remontée, les faisceaux sont temporairement interrompus, ce qui est détecté par les récepteurs 6.

Dans le mode de réalisation de la fig. 2, une touche 7 selon l'invention a une base modifiée par rapport à celle de la fig. 1.

Dans cette fig. 2, la base a une section en L avec une plaque horizontale 8 équivalente à la plaque 4 de la fig. 1 ainsi qu'une plaque verticale 9 en saillie vers le haut dont la hauteur est sensiblement supérieure à l'épaisseur de la plaque 8.

Là encore, la base est représentée en traits pleins dans une position intermédiaire et en traits interrompus dans ses positions extrêmes haute et basse.

On voit que, dans la position haute de la touche, les deux faisceaux issus des sources 5' et 5'' ne sont pas interrompus et sont donc par conséquent détectés par les récepteurs 6' et 6''.

Lorsque la touche arrive à un certain degré d'enfoncement, les deux faisceaux sont interrompus. Lorsque l'enfoncement se poursuit, le faisceau issu de la source 5'' est à nouveau libéré et reste ininterrompu jusqu'à ce que la touche atteigne sa position basse.

Par contre, lorsque l'enfoncement se poursuit, le faisceau issu de la source 5' demeure interrompu jusqu'à la position enfoncée de la touche.

Cette touche se comporte par conséquent comme une touche conventionnelle à l'égard du faisceau issu de la source 5' alors que le faisceau issu de la source 5'' n'est interrompu que temporairement au cours de l'enfoncement ou de la remontée de la touche.

Dans le mode de réalisation de la fig. 3, une touche 10 comporte une base 11, percée de deux conduits de lumière 12 et 13 superposés, qui, dans le cas présent, sont de sections rectangulaires et sont séparés par une cloison intermédiaire 14 d'épaisseur inférieure à la course de la touche.

Un autre conduit de lumière 15, est réalisé dans la base 11 incliné par rapport aux conduits 12 et 13 et au niveau approximatif du conduit 13.

Les conduits 12 et 13 sont parallèles au faisceau lumineux allant de la source 5'' au récepteur 6'' et le conduit 15 est parallèle au faisceau allant de la source 5' à la source 6'.

La touche 10 est représentée ici dans sa position haute où le faisceau issu de la source 5'' traverse le conduit 13 et où le faisceau issu de la source 5' traverse le conduit 15.

Lorsque la touche 10 est progressivement enfoncée, le faisceau lumineux issu de la source 5' est définitivement interrompu, ce qui est détecté par le récepteur 6', tandis que le faisceau lumineux issu de la source 5'' n'est interrompu que temporairement par la cloison 14, ce qui est détecté par le récepteur 6''.

La touche 10 se comporte par conséquent à l'égard des deux faisceaux lumineux comme la touche 7.

La touche 16 représentée à la fig. 4 diffère de la touche 10 par le fait qu'elle comporte uniquement le conduit de lumière supérieur 12 et sa cloison inférieure 14.

En position haute de la touche, les faisceaux lumineux issus des sources 5' et 5'' se croisent sous la base 17 de la touche sans être interrompus, puis, lorsque la touche est progressivement enfoncée, le faisceau issu de la souce 5' est définitivement interrompu tandis que le faisceau issu de la source 5'' n'est que provisoirement interrompu par la cloison 14 puis est rétabli à travers le conduit de lumière 12.

La touche 16 se comporte par conséquent comme les touches 7 et 10.

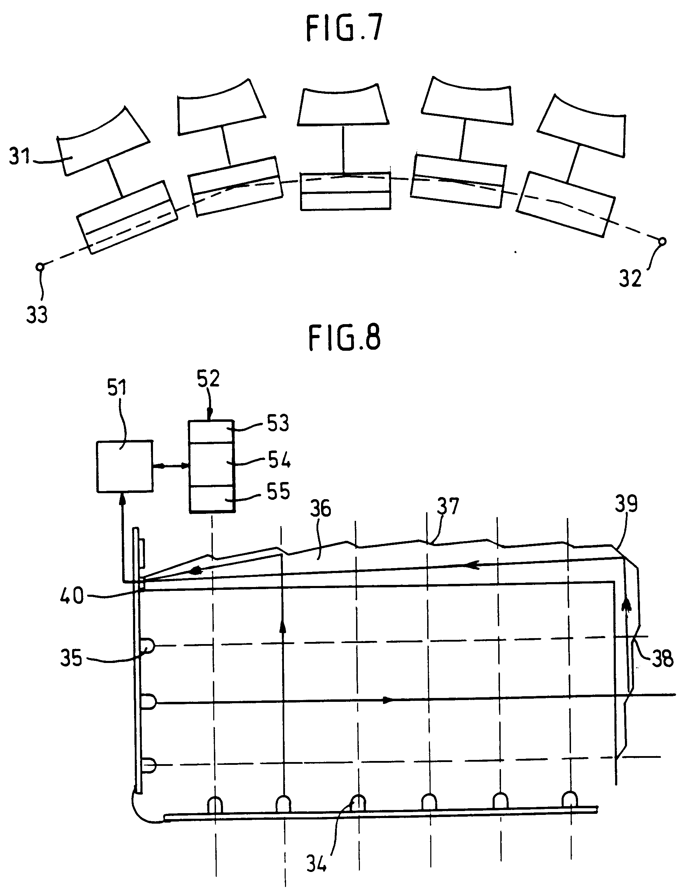

La touche 18 de la fig. 5 possède un corps 19 qui, en plan, possède une forme de croix et dans lequel sont formées deux paires de conduits de lumière perpendiculaires à savoir la paire de conduits superposés 20 et 21 et la paire de conduits superposés 22 et 23.

Les conduits 20 et 21 sont séparés par une cloison 24 et les conduits 22 et 23 sont séparés par une cloison 25, la somme des épaisseurs des cloisons 24 et 25 étant inférieure à la course de la touche.

Lorsque la touche est dans sa position haute, les deux faisceaux issus des sources 5 traversent les conduits 21 et 23 puis lorsque la touche est enfoncée, les faisceaux sont temporairement interrompus par les cloisons 24 et 25 et sont enfin rétablis dans la position basse de la touche représentée à la fig. 5 à travers les conduits 20 et 22.

La touche 18 se comporte donc comme la touche 1 vis-à-vis des faisceaux lumineux issus des sources 5.

Les touches 1 et 7 des figs. 1 et 2 respectivement présentent l'avantage d'une base très simple à réaliser mais les conduits de lumière des touches 10, 16 et 18 des figs. 3, 4 et 5 respectivement permettent une coupure plus franche du faisceau lumineux en position intermédiaire provoquent une atténuation plus faible du faisceau selon l'axe des conduits, et permettent en outre une légère cambrure du clavier sur lequel les touches sont disposées.

Les bases des touches peuvent être réalisées dans une matière plastique opaque quelconque facile à mouler et pouvant présenter des surfaces lisses réfléchissant la lumière sous forte incidence dans les conduits de lumière et absorbant la lumière sous faible incidence comme il est utile dans l'espace compris entre deux conduits pour éviter une diffusion de lumière parasite.

Si l'on se réfère maintenant à la fig. 6, on voit une touche 26, avec son cabochon 27, sa base 28 et la tige de liaison 29 entre le cabochon et la base.

L'axe de la tige 29 est décentré par rapport à l'axe 30 de la colonne de la touche 26 d'un quart de pas des touches dans une rangée, et est décentré d'un huitième de pas par rapport à l'axe 30' du cabochon.

De la sorte, il est possible, tout en utilisant un seul type de base et un seul type de cabochon, de décaler les cabochons par quart de pas dans une rangée et de rangée à rangée, tout en conservant les bases de touches dans des positions fixes aux intersections de rangées et de colonnes orthogonales.

La fig. 7 illustre une rangée de touches 31 selon l'invention ainsi que la source lumineuse 32 et le récepteur 33 associés à cette rangée.

On voit sur cette figure que, du fait de la réflexion de la lumière sous forte incidence, le clavier peut être légèrement cadré notamment lorsque l'on utilise des touches à conduits de lumière comme illustré dans les figs. 3 à 5.

La fig. 8 illustre un clavier comportant sur un de ses côtés des sources lumineuses de colonnes 34 sur un des côtés adjacents des sources lumineuses de rangées 35 et un collecteur de lumière 36 en forme de L bordant les deux autres côtés du clavier.

Le collecteur 36 est réalisé en matière plastique tranparente par exemple en polycarbonate, ce dernier présentant l'avantage d'un indice de réfraction supérieur à 1,5 ce qui facilite les réflexions totales.

Le collecteur comprend sur son bord extérieur au clavier des facettes 37 en vis-à-vis des sources 34 et des facettes 38 en vis-à-vis des sources 35.

Il comporte en outre une facette 39 dans son angle pour des raisons qui seront exposées ci-après.

Un récepteur unique de lumière 40 (ou l'extrémité d'une fibre optique menant à un tel récepteur) est disposé à l'extrémité d'une des branches du collecteur 36 à côté des sources lumineuses de ligne 35.

La lumière émise par les sources 34 est réfléchie par les facettes correspondantes 37 directement vers le détecteur 40.

Les faisceaux lumineux issus des sources 35 sont tout d'abord réfléchis par les facettes 38 vers la facette 39 puis de cette facette vers le récepteur 40.

L'allumage des sources 34 et 35 est effectué séquentiellement de sorte que l'on sait quelle source émet le faisceau lumineux reçu par le détecteur 40 à un instant donné par la position de cette source dans le cycle d'allumage.

Si, à cet instant le faisceau est interrompu, on en déduit qu'une touche de la colonne ou de la rangée correspondante est enfoncée. Une nouvelle extinction interviendra au cours du même cycle lorsque la source de la rangée ou de la colonne respectivement de cette touche sera allumée et que son faisceau sera également interrompu.

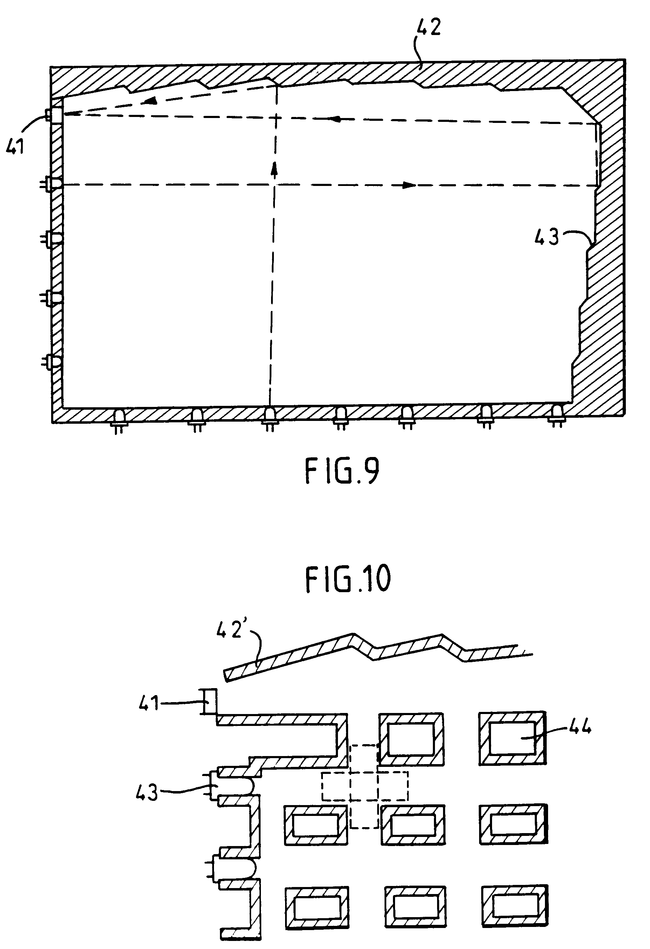

La fig. 9 illustre une variante n'utilisant également qu'un récepteur 41 mais dans laquelle le conduit de lumière est remplacé par un cadre 42 également en forme de L réalisé par exemple en matière plastique opaque moulée et formant des facettes 43 métallisées pour assurer une bonne réflexion de la lumière.

La fig. 10 représente un cadre 42' réalisé dans une bande de matière plastique opaque thermoformée, cette bande 42' faisant partie d'un boîtier assurant le support des sources de lumière 43 et du récepteur 41 et formant des plots écrans 44 pour des bases de touches en croix telles que celles de la fig. 5. Un tel agencement est non seulement particulièrement économique mais il assure en outre une canalisation adéquate des faisceaux lumineux entre les différentes touches.

Un autre mode de réalisation consiste à remplacer la bande 42' et le récepteur de lumière 41 par une bande en L d'un matériau photodétecteur pour fournir le signal d'occultation des sources lumineuses.

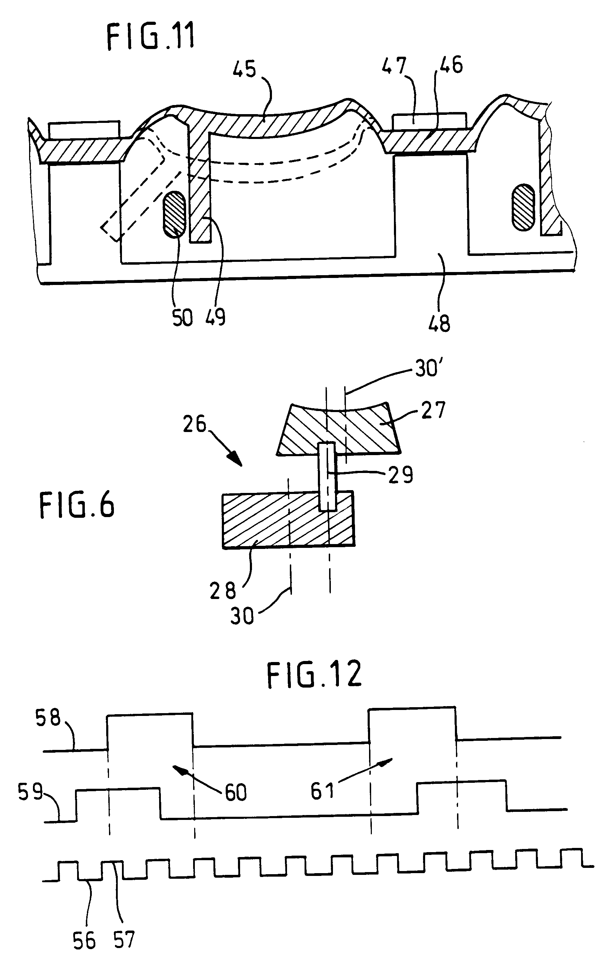

Dans le mode de réalisation de la fig. 11, l'ensemble du clavier est recouvert d'une nappe d'élastomère formant des touches 45 déformables, entre des parties de maintien 46 fermement maintenues entre les parties rigides hautes 47 et basses 48 du boîtier du clavier.

Les touches 45 présentent à leur surface inférieure une ou deux saillies latérales 49 qui, dans la position relâchée, de la touche représentée en traits pleins sont ici sensiblement verticales.

La fig. 11 représente également un faisceau lumineux 50 vu ici en coupe.

Lorsque la touche 45 est enfoncée pour être amenée dans sa position représentée en traits interrompus, la saillie 49 interrompt temporairement le faisceau lumineux 50 du fait de son basculement puis le laisse de nouveau passer lorsque la touche est complètement enfoncée. Le faisceau 50 est de nouveau temporairement interrompu lorsque la touche est relâchée.

Chaque touche 45 peut posséder une seule saillie 49 utilisée pour couper les deux faisceaux qui se croisent au niveau de cette touche ou deux saillies coupant chacune l'un des faisceaux.

Si l'on revient maintenant à la fig. 8, on voit que le récepteur 40 est relié par l'intermédiaire d'un circuit de mise en forme non représenté à une unité de traitement 51 elle-même reliée à une mémoire 52 contenant une première table 53 dans laquelle sont mémorisées les touches donnant un signal transitoire pendant le cycle de balayage en cours, cette table étant remplie au fur et à mesure de l'acquisition, une deuxième table 54 dans laquelle sont mémorisées les touches ayant donné un signal au cours du cycle précédent et une troisième table 55 dans laquelle sont mémorisées les touches enfoncées depuis plusieurs cycles et non relâchées.

Chaque cycle comprend un temps d'acquisition 56 et un temps de traitement 57 (fig. 12).

Le temps d'acquisition correspond au balayage des sources lumineuses et à la mise à jour de la table 53 et le temps de traitement correspond aux mises à jour des tables 54 et 55. On remarquera que la table 55 est nécessaire dans un clavier selon l'invention puisque le signal fourni par une touche est transitoire et qu'elle ne fournit plus de signal lorsqu'elle est enfoncée.

En l'absence de touche enfoncée, le cycle peut être écourté et limité par exemple à un balayage de colonnes, les sources de rangées n'étant pas balayées.

La fig. 12 représente, en 58, le signal correspondant à la colonne P et en 59, le signal correspondant à la colonne Q lorsque la touche de colonne P et de rangée Q est enfoncée en 60 et relâchée en 61.

Le décalage des signaux est obtenu par exemple par un décalage vertical des faisceaux de colonnes et de rangées de manière à distinguer l'enfoncement du relâchement d'une touche. On peut également décaler les zones de réception des faisceaux, ou la position des zones opaques dans les bases de touche.

Afin d'éliminer les signaux dus à des touches partiellement enfoncées, c'est à dire ne donnant, soit uniquement dans les colonnes, soit à la fois dans les colonnes et les rangées, qu'une seule transition pour un enfoncement et un relâchement, on ne prend en compte un signal de colonne qu'après avoir détecté la fin d'un signal de rangée.

**Revendications**

1.- Clavier optique matriciel muni de touches mobiles entre une position relâchée et une position enfoncée, chaque touche comportant des moyens d'interruption aptes à interrompre, en vu de l'identification de la touche, au moins deux faisceaux lumineux, caractérisé par le fait que lesdits moyens d'interruption (4; 49) sont agencés pour laisser passer au moins un desdits faisceaux lorsque la touche est en position relâchée ou en position enfoncée, et pour interrompre ledit faisceau pendant une fraction de la course de la touche entre ses positions relâchée et enfoncée.

2.- Clavier selon la revendication 1, dans lequel ledits moyens d'interruption comprennent une base (4; 8) rigidement reliée au cabochon (2) de la touche, ladite base ayant, dans la direction de déplacement de la touche, une dimension inférieure à la course de la touche.

3.- Clavier selon la revendication 1, dans lequel lesdits moyens d'interruption comprennent une base (17) rigidement reliée au cabochon de la touche, ladite base comportant au moins un conduit de lumière (12) pour laisser passer le faisceau lumineux lorsque la touche est en position enfoncée, la cloison inférieure (14) dudit conduit ayant une épaisseur inférieure à la course de la touche.

4.- Clavier selon la revendication 3, dans lequel ladite base comporte deux conduits de lumière (12, 13) superposés pour laisser passer le faisceau lumineux lorsque la touche est dans ses positions relâchée et enfoncée respectivement, la cloison (14) de séparation entre lesdits conduits ayant une épaisseur inférieure à la course de la touche.

5.- Clavier selon l'une quelconque des revendications 1 à 4, dans lequel lesdits moyens d'interruption sont agencés pour interrompre deux faisceaux lumineux, les fractions de course de la touche pendant lesquelles les deux faisceaux lumineux sont interrompus étant décalés.

6.- Clavier selon la revendication 5, dans lequel lesdits moyens d'interruption (9, 17) sont agencés pour interrompre un desdits faisceaux pendant une fraction de la course de la touche comprenant la position enfoncée de la touche.

7.- Clavier selon l'ensemble des revendications 3 et 5, la base de chaque touche comprenant au moins un conduit de lumière pour chacun des deux faisceaux lumineux, ladite base (19) ayant une forme de croix dont les branches sont parallèles à chacun des faisceaux lumineux.

8.- Clavier selon l'une quelconque des revendications 2 à 7, dans lequel une tige de liaison (29) entre la base et le cabochon de la touche est décentrèe par rapport à l'axe de la colonne de la touche et par rapport à l'axe du cabochon.

9.- Clavier selon la revendication 1, dans lequel chaque touche consiste en un emplacement déformable d'une membrane (45), lesdits moyens d'interruption comprenant une saillie excentrée (49) du côté inférieur de la touche, ladite saillie coupant le faisceau lumineux lors de l'enfoncement de la touche par déformation de ladite membrane.

10.- Clavier selon l'une quelconque des revendications 1 à 9, comprenant une pluralité de sources lumineuses (34, 35) correspondant chacune soit à une rangée de touches soit à une colonne de touches du clavier matriciel, un détecteur de lumière unique (40) et des moyens réfléchissants (37, 38, 43) pour réfléchir les faisceaux lumineux vers le détecteur de lumière, les sources lumineuses étant activées en séquence.

11.- Clavier selon la revendication 10, comportant un conduit de lumière monobloc en matériau transparent situé sur les deux bords du clavier opposés aux bords où sont montées les sources lumineuses, les moyens réfléchissants étant constitués de facettes réalisées du côté extérieur du conduit de lumière par rapport au clavier.

12.- Clavier selon l'une quelconque des revendications 1 à 9, comprenant une pluralité de sources lumineuses (34,35) correspondant chacune soit à une rangée de touches, soit à une colonne de touches du clavier matriciel, et une bande en matériau photodétecteur pour fournir un signal d'occultation des sources.

13.- Clavier selon l'une quelconque des revendications 1 à 12, comportant une pluralité de sources lumineuses activées cycliquement pour former lesdits faisceaux lumineux, des moyens de mémorisation (52) comprenant des moyens (53) pour mémoriser les touches ayant donné lieu à un signal au cours du cycle en cours, des moyens (54) pour mémoriser les touches ayant donné lieu à un signal au cours du cycle précédent, et des moyens (55) pour mémoriser les touches en position enfoncée depuis plusieurs cycles, et des moyens de traitement (51) des informations mémorisées pour identifier les touches enfoncées et leur ordre d'enfoncement.

FIG.1  FIG.2  FIG.3  FIG.4  FIG.5

# FIG.7

# FIG.8

FIG.9

FIG.10

FIG.11

45    47    46

50    49    48

FIG.6

30'

26    27

29

28    30

FIG.12

58

59

60    61

56    57

Office européen
des brevets

**RAPPORT DE RECHERCHE EUROPEENNE**

Numero de la demande

EP    92 40 0230

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | US-A-3 519 116 (KOEHN)<br>* colonne 2, ligne 21 - colonne 3, ligne 33 *<br>* colonne 4, ligne 18 - colonne 5, ligne 5 *<br>* colonne 5, ligne 15 - ligne 29 *<br>* figures * | 1-7,12 | H03K17/969 |
| Y | DE-A-2 249 222 (SOLARTRON ELECTRONIC GROUP LTD.)<br>* page 11, dernier alinéa - page 12, alinéa 1; figure 8 * | 1-7,12 | |
| A | IBM TECHNICAL DISCLOSURE BULLETIN<br>vol. 23, no. 11, Avril 1981,<br>pages 4998 - 4999;<br>W.S. DUNCAN, J.M. HIGDON: 'Optical keyboard'<br>* le document en entier * | 1,8,10 | |
| A | DE-A-3 535 551 (BRÜNINGHAUS)<br>* colonne 3, ligne 39 - ligne 59 *<br>* colonne 4, ligne 43 - ligne 54 *<br>* figures 2,3 * | 1,9 | |
| | | | **DOMAINES TECHNIQUES RECHERCHES (Int. Cl.5)** |
| A | WO-A-8 705 759 (SOULOUMIAC)<br>* page 8, ligne 25 - page 9, ligne 4 *<br>* page 10, ligne 1 - ligne 3; figure 6 * | 1,10,11 | H03K<br>G02B<br>B41J<br>G06K<br>H03M |

Le présent rapport a été établi pour toutes les revendications

| Lieu de la recherche | Date d'achèvement de la recherche | Examinateur |
|---|---|---|
| LA HAYE | 12 MAI 1992 | LIPP, G. |